(19) Europäisches Patentamt / European Patent Office / Office européen des brevets

(11) **EP 3 381 051 B1**

(12) **EUROPÄISCHE PATENTSCHRIFT**

(45) Veröffentlichungstag und Bekanntmachung des Hinweises auf die Patenterteilung:
**22.09.2021 Patentblatt 2021/38**

(21) Anmeldenummer: **16798139.8**

(22) Anmeldetag: **17.11.2016**

(51) Int Cl.:
**H01L 23/29** $^{(2006.01)}$

(86) Internationale Anmeldenummer:
**PCT/EP2016/077919**

(87) Internationale Veröffentlichungsnummer:
**WO 2017/089207 (01.06.2017 Gazette 2017/22)**

(54) **ELEKTRISCHE VORRICHTUNG MIT EINER UMHÜLLMASSE**

ELECTRICAL DEVICE WITH AN ENCAPSULATION

DISPOSITIF ÉLECTRIQUE COMPRENANT UNE MATIÈRE D'ENROBAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.11.2015 DE 102015223443**

(43) Veröffentlichungstag der Anmeldung:
**03.10.2018 Patentblatt 2018/40**

(73) Patentinhaber: **Robert Bosch GmbH**
**70442 Stuttgart (DE)**

(72) Erfinder:
• **SCHUETT, Klaus-Volker**
**73249 Wernau (DE)**
• **HARZER, Andreas**
**71701 Schwieberdingen (DE)**
• **HEJTMANN, Georg**
**74395 Mundelsheim (DE)**
• **TAEFFNER, Ulrike**
**70569 Stuttgart (DE)**
• **EPPLE, Lars**
**70839 Gerlingen (DE)**
• **STEDILE, Petra**
**73732 Esslingen (DE)**

(56) Entgegenhaltungen:
WO-A1-02/096636 WO-A1-2013/069782
DE-A1-102013 112 267 JP-A- S6 151 859
JP-A- 2003 183 498 US-A1- 2003 194 544
US-A1- 2008 299 300

• ROLAND BAYER ET AL: "Dry Mortars", 1 January 2005 (2005-01-01), ULLMANN'S ENCYCLOPEDIA OF INDUSTRIAL CHEMISTRY, WILEY-VCH, WEINHEIM , DE, PAGE(S) 1 - 26, XP003026699, ISBN: 978-3-527-30385-4 [retrieved on 2003-01-15]

EP 3 381 051 B1

**Beschreibung**

Die vorliegende Erfindung betrifft eine elektrische Vorrichtung mit einem elektrischen Bauteil, welches von einer Umhüllmasse zumindest teilweise umhüllt ist sowie ein Verfahren zur Herstellung einer derartigen elektrischen Vorrichtung.

Stand der Technik

Die Erhöhung der Zuverlässigkeit und der Effizienz sowie die Senkung der Kosten von Leistungselektronikmodulen und robusten Sensorsystemen sind heutzutage von höchster Bedeutung. Die aktuellen Umhüllmaterialien (EpoxidVerbindungen, Silikonmassen) sind auf einen Temperaturbereich von unter 200°C begrenzt. Durch die Erschließung des Temperaturbereiches von bis zu 300°C bzw. 350°C für Umhüllmaterialien kann der Betriebsbereich von modernen Leistungshalbleitern (z.B. SiC) über 200°C hinaus erweitert werden, ohne das auf die Zusatzfunktion eines Umhüllmaterials (z.B. Schutz vor Umwelteinflüssen, verbesserte Thermik) verzichtet werden muss.

Aus der DE 10 2013 112267 A1 ist ein Halbleitermodul gemäß dem ersten Teil des Anspruchs 1 bekannt.

Die Umhüllmasse weist hierbei zur Erhöhung der Zugfestigkeit elektrisch nicht-leitende anorganische Fasern auf.

Die US 2008/299300 A1 offenbart eine elektrische Vorrichtung mit einem elektrischen Bauteil, welches von einer Zementmasse umhüllt ist.

Offenbarung der Erfindung

Gegenstand der vorliegenden Erfindung ist eine elektrische Vorrichtung mit einem elektrischen Bauteil, welches von einer eine Zementmasse aufweisenden Umhüllmasse zumindest teilweise umhüllt ist, wie in Anspruch 1 definiert.

Gegenstand der vorliegenden Erfindung ist ferner ein Verfahren zur Herstellung einer elektrischen Vorrichtung mit einem elektrischen Bauteil, welches von einer eine Zementmasse aufweisenden Umhüllmasse zumindest teilweise umhüllt wird, wie in Anspruch 10 definiert.

Gegenstand der vorliegenden Erfindung ist außerdem die Verwendung einer Masse aufweisend eine Zementmasse als Umhüllmasse für ein elektrisches Bauteil einer elektrischen Vorrichtung, wobei die Umhüllmasse ferner ein erstes Material aufweisende Partikel und ein zweites Material aufweisende Fasern aufweist, wie in Anspruch 12 definiert.

Das elektrische Bauteil kann bspw. ein Halbleiterbauelement, ein Sensorelement, eine Induktivität, eine Kapazität, eine Batteriezelle, ein Batteriemodul oder eine Schaltungsanordnung sein. Unter einem elektrischen Bauteil kann im Rahmen der vorliegenden Erfindung jedoch jegliches aktive und passive Bauelement bzw. Hochleistungs-Bauelement verstanden werden. Die elektrische Vorrichtung kann hierbei ein Trägersubstrat aufweisen, auf dem das elektrische Bauteil angeordnet ist.

Unter einem Zement kann im Rahmen der vorliegenden Erfindung ein anorganisches, metallfreies, hydraulisches Bindemittel verstanden werden. Der Zement erhärtet hierbei hydraulisch, d.h. es findet eine chemische Reaktion mit Wasser statt unter Bildung stabiler, unlöslicher Verbindungen. Hierbei kann der Zement zu Beginn des Verfahrens bzw. vor der Hydratation als feingemahlenes Pulver ausgebildet sein, welches mit Wasser bzw. Zugabewasser unter der Bildung von Hydraten reagiert, erstarrt und erhärtet. Die Hydrate können dabei Nadeln und/oder ausbilden, welche sich verzahnen und somit zu einer hohen Festigkeit des Zementes führen. Im Gegensatz dazu erhärtet ein Phosphatzement nicht hydraulisch. Es findet eine Säure-Basen-Reaktion unter Bildung eines Salzgels statt, welches später zu einer meist amorphen Masse erstarrt. Bei der Säure-Base-Reaktion werden H+ (Wasserstoff-Ionen) ausgetauscht.

Der Zement kann überwiegend aus Calciumaluminaten bestehen und während der Hydratation Calciumaluminathydrate ausbilden. Es ist vorteilhaft, wenn die Zementmasse Tonerdezement aufweist, insbesondere aus Tonerdezement besteht. Tonerdezement (Kurzzeichen CAC) ist nach DIN EN 14647 europäisch geregelt. Tonerdezement besteht vorwiegend aus Monocalciumaluminat ($CaO * Al_2O_3$).

Der Tonerdezement kann bspw. folgende Zusammensetzung aufweisen:

- $Al_2O_3$: größer oder gleich 67,8 Gew.-%
- $CaO$: kleiner oder gleich 31,0 Gew.-%
- $SiO_2$: kleiner oder gleich 0,8 Gew.-%
- $Fe_2O_3$: kleiner oder gleich 0,4 Gew.-%

Die Partikel können als Füllstoff ausgebildet sein. Die Partikel können als Kugeln, unregelmäßigen Polyeder, Bruchstücke und/oder Plättchen ausgebildet sein. Die Partikel weisen erfindungsgemäß ein erstes Material auf, welches eine höhere Wärmeleitzahl aufweist als der Zement der Zementmasse. Der Zement weist eine Wärmeleitzahl von 1 W/(m.K) auf. Demnach weist das erste Material der Partikel eine Wärmeleitzahl von größer 2 W/(m.K) auf. Die Partikel können vorzugsweise auch aus dem ersten Material bestehen. Bei dem ersten Material kann es sich auch um eine Materialgruppe handeln.

Die Fasern können als Vollfasern, Hohlfasern und/oder Nanotubes ausgebildet sein. Die Fasern weisen erfindungsgemäß ein zweites Material auf, welches eine höhere Wärmeleitzahl aufweist als der Zement der Zementmasse. Demnach weist das zweite Material ebenfalls eine Wärmeleitzahl größer 2 W/(m.K) auf. Die Fasern können vorzugsweise auch aus dem zweiten Material bestehen. Bei dem zweiten Material kann es sich auch um eine Materialgruppe handeln. Die Fasern können einen Durchmesser im Bereich von größer oder gleich 100 nm bis kleiner oder gleich 100 μm aufweisen. Die Fasern können eine Länge im Bereich von größer oder gleich 1 μm bis kleiner oder gleich 100μm aufweisen.

Die Partikel und die Fasern können in eine trockene Zementmasse bzw. Zementpulver-Mischung eingemischt werden, d.h. bevor ggf. das Zugabewasser beigemengt wird. Die Partikel und die Fasern können aber auch in die nasse Zementmasse bzw. Zementpulver-Mischung eingemischt werden, d.h. nachdem ggf. das Zugabewasser beigemengt wurde.

Unter einer Umhüllmasse kann im Rahmen der vorliegenden Erfindung jegliche Art von Verkapselung (Packaging) verstanden werden. Die Umhüllmasse kann als Zementkomposit ausgebildet sein. D.h., mit anderen Worten, dass die Umhüllmasse eine Zementmatrix mit den Partikeln und den Fasern aufweisen kann. Die Umhüllmasse kann folgende Zusammensetzung aufweisen:

- Bindemittel Tonerdezement: größer oder gleich 8 Gew.-% bis kleiner oder gleich 47 Gew.-% (bspw. SECAR 71)
- Reaktionsmittel Wasser: größer oder gleich 10 Gew.-% bis kleiner oder gleich 28 Gew.-%
- Fasern und/oder Nanoröhren: größer oder gleich 5 Gew.-% bis kleiner oder gleich 85 Gew.-%
- Füllstoff: größer oder gleich 25 Gew.-% bis kleiner oder gleich 82 Gew.-%

Der Schritt des Wärmebehandels kann im Rahmen der vorliegenden Erfindung einen Hydratationsschritt und/oder Abbindeschritt und/oder Trocknungsschritt und/oder Aushärtungsschritt umfassen. Die Wärmebehandlung kann einen Temperschritt in einem Temperofen umfassen. Die Wärmebehandlung kann in einem Temperaturbereich von größer oder gleich 40 °C bis gleicher oder gleich 95 °C erfolgen.

Durch das Vorsehen von Partikeln und Fasern, welche jeweils eine höhere Wärmeleitzahl als der Zement der Zementmasse aufweisen, ist es nun möglich, die Wärmeleitfähigkeit der Umhüllmasse deutlich zu steigern und damit die Wärmeableitung von dem elektrischen Bauteil erzeugten Wärme zu erhöhen. Dieser Effekt tritt nicht nur aufgrund der Materialeigenschaften, d.h. der höheren Wärmeleitzahl der Partikel und der Fasern auf, sondern insbesondere aufgrund der Anordnung der Partikel und Fasern, da somit eine verbesserte Wärmeübertragung von einem Partikel bzw. einer Faser zum anderen Partikel bzw. zur anderen Faser ermöglicht wird. Somit kann das elektrische Bauteil sehr effizient gekühlt werden, wodurch wiederum höhere Betriebstemperaturen ermöglicht werden. Dies führt ferner zu einer Effizienzsteigerung und einer Bauraumreduzierung der elektrischen Vorrichtung.

Es ist vorteilhaft, wenn das erste Material der Partikel und/oder das zweite Material der Fasern eine Kristallstruktur aufweist, insbesondere ein keramisches oder ein metallisches Material ist. Besonders vorteilhaft ist es, wenn die Partikel und die Fasern aus einem bzw. dem gleichen keramischen und/oder aus einem metallischen Material bestehen. Es ist ferner vorteilhaft, wenn die Differenz der thermischen Ausdehnungskoeffizienten (CTE) des ersten Materials, des zweiten Materials und des Zements gering ist. Das erste Material und das zweite Material können ausgewählt sein aus der Gruppe bestehend aus: $Al_2O_3$, Alpha-$Si_3N_4$, Hex. BN, SiC und AlN. Der thermische Ausdehnungskoeffizient des Zements liegt im Bereich von $4\text{-}12 \times 10^{-6}$/K. Diese Materialien eignen sich besonders gut, da sie eine hohe Wärmeleitzahl und einen thermischen Ausdehnungskoeffizienten aufweisen, welcher nahe bei dem des Zements liegt.

Es ist ferner vorteilhaft, wenn die Partikelgrößenverteilung der Partikel in der Umhüllmasse unimodal oder bimodal ist. Hierbei ist es vorteilhaft, wenn das Maximum der unimodalen Partikelgrößenverteilung bei ungefähr 10 μm oder 100 μm und wenn die Maxima der bimodalen Partikelgrößenverteilung bei ungefähr 10 μm und ungefähr 100 μm liegen. Erfindungsgemäß ist die Partikelgrößenverteilung der Partikel der Fuller-Verteilung mit einem Körnungsexponent q von 0,4 angenähert.

Eine Häufigkeitsverteilung mit nur einem Gipfel wird "unimodal" oder "monomodal" genannt. Ein typisches Beispiel dafür ist die Normalverteilung, welche außerdem symmetrisch ist. Viele unimodale (eingipflige) Häufigkeitsverteilungen sind dagegen asymmetrisch (z. B. "links-schief"). Bei einer unimodalen Partikelgrößenverteilung haben Partikel einer mittleren Partikelgröße die größte Häufigkeit. Es gibt keine weiteren Hauptmaxima in der Partikelgrößenverteilung. Es kann aus herstellungstechnischen Gründen ein oder mehrere Nebenmaxima bei für die Messung nicht relevanten Partikelgrößen geben. Die entsprechende unimodale Partikelgrößenverteilung kann um das Maximum mit der mittleren Partikelgröße scharf oder breit ausgestaltet sein. Bei einer "scharfen" Partikelgrößenverteilung nimmt die Häufigkeit von dem Maximum ausgehend stark ab. Bei einer breiten Partikelgrößenverteilung weisen auch Partikelgrößen, die einen größeren Abstand zu der mittleren Partikelgröße haben, noch eine relevante Häufigkeit auf.

Eine bimodale Verteilung ist in der Mathematik eine Wahrscheinlichkeitsverteilung oder Häufigkeitsverteilung, bei der die Dichte bzw. deren Schätzung zwei Modi aufweist. Sie ist eine multimodale Verteilung (auch mehrgipflig), da sie im Gegensatz zur unimodalen Verteilung mehr als ein Maximum aufweist. Eine bimodale Verteilung kann sowohl symmetrisch als auch asymmetrisch sein. Eine bimodale Partikelgrößenverteilung kann angesehen werden als Überlagerung von unimodalen Partikelgrößenverteilungen. Das erste Material der Partikel kann auch eine Materialgruppe umfassen. Demnach können im Rahmen dieser Erfindung bei der bimodalen Partikelgrößenverteilung die Partikel der beiden Modi nicht nur unterschiedliche Partikelgrößen, sondern auch unterschiedliche Materialien aufweisen.

Es hat sich herausgestellt, dass neben der chemisch-mineralogischen Beschaffenheit insbesondere die Partikelform, die Partikelgröße und die Partikelabstufung bzw. die Partikelgrößenverteilung der Partikel bzw. des Füllstoffes für die Güte der Umhüllmasse bzw. des Zementkomposits von großer Bedeutung sind. Von entscheidender Bedeutung für die Dichte und die Festigkeit der Umhüllmasse bzw. des Zementkomposits ist die Partikelgröße und die Partikelgrößenverteilung bzw. das richtige Verhältnis der einzelnen Partikelgrößenklassen zueinander. Einem Aspekt der Erfindung liegt nun die Erkenntnis zugrunde, dass die Wärmeleitfähigkeit der Umhüllmasse bzw. des Zementkomposits mit höherer Packungsdichte der Partikel bzw. des Füllstoffes steigt. Demnach sind die beiden zu erfüllenden Anforderungen: geringste Hohlräume zwischen den Partikeln und geringste Oberfläche der Partikel.

Es können bspw. bei einer unimodalen Partikelgrößenverteilung keramische oder metallische Partikel mit einem Durchmesser von ungefähr 10 μm (größte Häufigkeit) und keramische oder metallische Fasern mit einem Durchmesser von bis 10 μm kombiniert werden. Alternativ können auch keramische oder metallische Partikel mit einem Durchmesser von ungefähr 100 μm (größte Häufigkeit) und keramische oder metallische Fasern mit einem Durchmesser von bis 100 μm kombiniert werden. Die Partikel verfüllen die Leerräume zwischen den Fasern und begünstigen damit eine netzwerkartige Ausrichtung der Fasern, sodass zusätzliche Wärmeleitpfade in der Umhüllmasse entstehen, welche die gesamte Wärmeleitfähigkeit erhöhen.

Bei der bimodalen oder auch bei der multimodalen Partikelgrößenverteilung wird der o.g. Effekt verstärkt, da die kleineren Partikel die Leerräume zwischen den größeren Partikeln füllen und somit die (Packungs-)Dichte und die Anzahl der Kontaktpunkte weiter erhöhen. Durch die bimodale bzw. multimodale Partikelgrößenverteilung kann folglich die Wärmeleitfähigkeit zwischen den Partikeln und den Fasern und damit die Wärmeleitfähigkeit der gesamten Umhüllmasse weiter gesteigert werden.

Eine besonders hohe (Packungs-)Dichte wird durch eine Partikelgrößenverteilung, welche der Fuller-Verteilung angenähert ist, erzielt. Die Partikel-/Kornpackung nach Fuller lässt sich wie folgt beschreiben:

$$A_{(d)} = \left( \frac{d}{d_{max.}} \right)^q$$

wobei

$A_{(d)}$: Massenanteil mit Korn-Ø kleiner d
$d_{max.}$: Größt-Ø des Korngemenges
d: Korn-Ø (0<d<$d_{max.}$)
q: Körnungsexponent ist.

Die hohlraumärmste Partikel-/Kornpackung bzw. das hohlraumärmste Partikel-/Korngemenge ergibt sich hierbei bei q = 0,4.

Die Partikel bilden ein Partikelgemenge aufweisend einer Vielzahl von Partikelgrößen aus, wobei das Partikelgemenge an die Fuller-Verteilung angenähert bzw. angepasst ist. Die Fuller-Verteilung entsteht hierbei durch die Überlagerung mehrerer uni- und/oder bimodal verteilter Partikelmengen. Folglich kann eine äußerst hohlraumarme Partikelverteilung erzielt werden, wobei die einzelnen Partikel in der Zementmasse viele Kontaktpunkte bzw. - flächen aufweisen, welche wiederum die Wärmeübertragung von Partikel zu Partikel erhöhen und somit die Wärmeleitfähigkeit der gesamten Zementmasse erhöhen können.

Die Partikel und die Fasern sind in der Zementmasse angeordnet. Demnach sind die Partikel und die Fasern von der Zementmasse umhüllt. Hierbei sind die Partikel und die Fasern homogen in der Zementmasse verteilt. Durch diese Maßnahme kann die von dem elektrischen Bauteil abgegebene Wärmemenge sehr effizient über die Zementmasse an die Partikel und Fasern geleitet, um dann von den Fasern an die Umgebung abgegeben zu werden.

Vorteilhaft ist es außerdem, wenn eine elektrisch isolierende Schicht vorgesehen ist, welche zwischen der Umhüllmasse und dem elektrischen Bauteil angeordnet ist. Die elektrisch isolierende Schicht kann vorzugsweise Parylene HT oder Zement (ohne die Partikel und Fasern) aufweisen oder daraus besteht. Durch diese Maßnahme wird gewährleistet, dass im Falle von elektrisch leitenden Fasern, das elektrische Bauteil von der Umhüllmasse mit den elektrisch leitenden Fasern elektrisch isoliert wird und dadurch keine Kurzschlüsse entstehen.

Außerdem ist es vorteilhaft, wenn der folgende Schritt zusätzlich vorgesehen ist: Ausrichten der Fasern nach dem Schritt des Aufbringens der Umhüllmasse auf das elektrische Bauteil. Durch diesen Schritt können die Fasern gezielt vom elektrischen Bauteil weg nach außen ausgerichtet werden. Durch diesen Schritt können die Fasern auch derart ausgerichtet werden, dass sie wie vorangehend erläutert eine Art Netzwerk bilden. Durch die gerichteten Wärmepfade bzw. die erhöhte Zahl an Wärmepfaden kann die erzeugte Wärmemenge schnell und effizient an die Umgebung abgeleitet werden.

Zeichnungen

Die Erfindung wird nachstehend anhand der beigefügten Zeichnungen beispielhaft näher erläutert. Es zeigen:

Fig. 1 eine Darstellung einer elektrischen Vorrichtung gemäß einem Ausführungsbeispiel der vorliegenden Erfindung;
Fig. 2 eine Darstellung einer elektrischen Vorrichtung gemäß einem weiteren Ausführungsbeispiel der vorliegenden Erfindung; und

Fig. 3 eine Darstellung einer elektrischen Vorrichtung gemäß einem weiteren Ausführungsbeispiel der vorliegenden Erfindung.

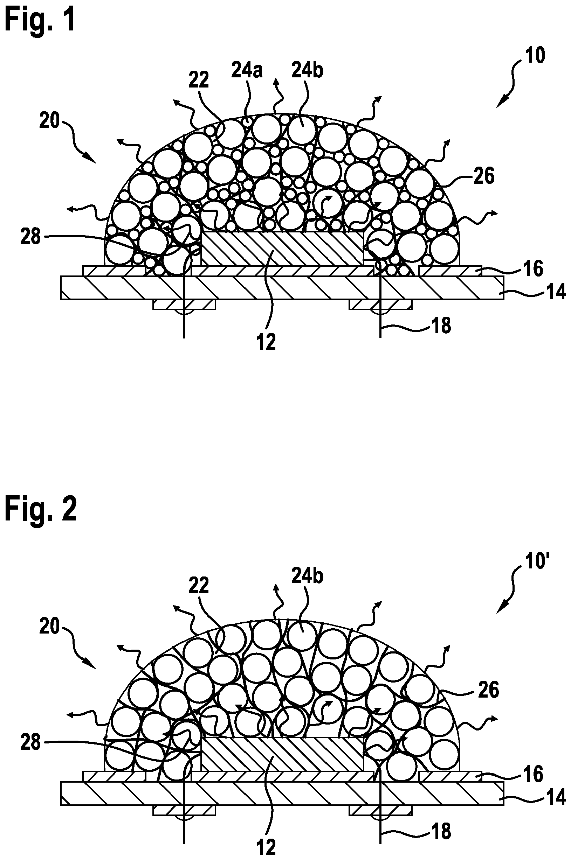

In Fig. 1 ist eine erfindungsgemäße elektrische Vorrichtung dargestellt, welche in ihrer Gesamtheit mit der Bezugsziffer 10 versehen ist.

Die elektrische Vorrichtung 10 weist ein elektrisches Bauteil 12 auf. Das elektrische Bauteil 12 ist als Halbleiterbauelement 12 ausgebildet. Das elektrische Bauteil 12 ist auf einem Trägersubstrat 14 angeordnet. Zwischen dem elektrischen Bauteil 12 und dem Trägersubstrat 14 ist eine Kupferschicht 16 angeordnet. Die Kupferschicht 16 hat hierbei mehrere Funktionen, nämlich die Wärmeanbindung und -abfuhr zu verbessern, eine elektrische Kontaktierungsmöglichkeit für das elektrische Bauteil 12 bereitzustellen und ggf. als Fließstop der Umhüllmasse beim Auftragen.

Das elektrische Bauteil 12 ist über Bonddrähte 18 mit der ihm gegenüberliegenden Seite des Trägersubstrats 14 verbunden, wodurch eine elektrische Kontaktierung des elektrischen Bauteils 12 von außen ermöglicht wird. Hierbei kann das Trägersubstrat 14 beispielsweise als eine Platte ausgebildet sein, in die ferner Leiterbahnen bzw. elektrische Kontakte zum Kontaktieren des elektrischen Bauteils 12 integriert sein können. Die Leiterbahnen können auch auf einer Oberfläche des Trägersubstrats 14 angeordnet sein. Das Trägersubstrat 14 kann zu einem Chip ausgebildet sein.

Die elektrische Vorrichtung 10 weist ferner eine Umhüllmasse 20 auf, welche eine Zementmasse 22 aufweist. Die Umhüllmasse 20 bzw. die Zementmasse 22 ist als Glob-Top ausgebildet. Die Umhüllmasse 20 bzw. die Zementmasse 22 ist an dem Trägersubstrat 14 angeordnet. Die Zementmasse 22 umhüllt hierbei das elektrische Bauteil 12 an den Flächen, welche von dem Trägersubstrat 14 unbedeckt sind. Demnach ist das elektrische Bauteil 12 vollständig durch das Trägersubstrat 14 und die Umhüllmasse 20 umhüllt. Die Zementmasse 22 bedeckt ferner auch einen Teil des Trägersubstrats 14, über den sie fest mit dem Trägersubstrat 14 verbunden ist.

Die Umhüllmasse 20 bzw. der Zementmasse 22 weist eine Vielzahl von Partikeln 24a, 24b, welche ein Partikelgemenge ausbilden, sowie eine Vielzahl von Fasern 26 auf. Demnach sind die Partikel 24a, 24b und die Fasern 26 von der Zementmasse 22 umhüllt. Die Partikel 24a, 24b und die Fasern 26 sind in der Zementmasse 22 verteilt angeordnet. Die Partikel 24a, 24b und die Fasern 26 sind im Wesentlichen homogen verteilt angeordnet. Erfindungsgemäß weisen die Partikel 24a, 24b und die Fasern 26 ein Material auf, welches jeweils eine höhere Wärmeleitzahl aufweist als der Zement der Zementmasse 22. Die Partikel 24a, 24b und die Fasern 26 bestehen hierbei aus einem keramischen Material. Wie aus Fig. 1 ersichtlich ist, verfüllen die Partikel 24a, 24b die Leerräume zwischen den Fasern 26, wodurch die Fasern 26 auseinander gehalten und eine Art dreidimensionales Netzwerk bilden. Dies führt dazu, dass zusätzliche Kontaktpunkte und damit Wärmeleitpfade in der Umhüllmasse 20 entstehen.

Eine von dem elektrischen Bauteil 12 abgegebene Wärmemenge 28 kann folglich besonders effizient über die Partikel 24a, 24b und insbesondere die Fasern 26 an die Umgebung abgeleitet werden.

In der bevorzugten Ausführungsform aus Fig. 1, ist die Partikelgrößenverteilung der Partikel 24a, 24b bimodal. Das erste Maximum der kleineren Partikel 24a liegt hierbei bei ca. 10 $\mu$m. Das zweite Maximum der größeren Partikel 24b liegt bei ca. 100 $\mu$m. Die Anzahl der unterschiedlichen Partikelgrößen kann verständlicherweise - bspw. abhängig davon, ob die Partikelgrößenverteilung an den Maxima breit oder scharf ausgebildet ist - stark variieren, wobei aus darstellerischen Gründen lediglich die Partikel mit den beiden größten Häufigkeiten (Maxima) eingezeichnet sind. Aufgrund der bimodalen Partikelgrößenverteilung und der entsprechenden Auswahl der Maxima, können die kleineren Partikel 24a die Leerräume zwischen den größeren Partikeln 24b füllen, wodurch eine hohe (Packungs-)Dichte des Partikelgemenges und folglich eine hohe Wärmeleitfähigkeit erzielt wird. Um eine optimale (Packungs-)Dichte zu erhalten, ist das Partikelgemenge eine Vielzahl weiterer (nicht dargestellter) Partikel mit unterschiedlichen Partikelgrößen auf, wobei die Partikelgrößenverteilung im Partikelgemenge der Fuller-Verteilung angenähert ist. Die hohlraumärmste Partikel-/Kornpackung bzw. das hohlraumärmste Partikel-/Korngemenge nach Fuller lässt sich wie folgt beschreiben:

$$ A_{(d)} = \left( \frac{d}{d_{max.}} \right)^q $$

wobei q = 0,4 gewählt ist.

In Fig. 2 ist eine weitere erfindungsgemäße elektrische Vorrichtung 10' dargestellt. Die elektrische Vorrichtung 10' ist analog zu der Vorrichtung 10 aus Fig. 1 aufgebaut. Die elektrische Vorrichtung 10' weist jedoch eine unimodale Partikelgrößenverteilung von Partikeln 24b auf. Das Maximum der Partikelgrößenverteilung der Partikel 24b kann bspw. bei ca. 100 $\mu$m liegen. Die Partikel 24b sind im Wesentlichen homogen verteilt angeordnet und füllen die Lücken zwischen den Fasern 26 auf. Die Partikel 24b und die Fasern 26 bestehen aus einem keramischen Material. Die Anzahl der unterschiedlichen Partikelgrößen kann auch hier verständlicherweise stak variieren, wobei aus darstellerischen Gründen lediglich die Partikel 24b mit der größten Häufigkeit (Maximum) eingezeichnet sind.

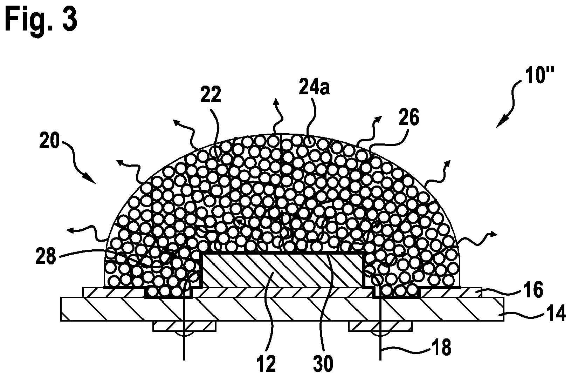

In Fig. 3 ist eine weitere erfindungsgemäße elektrische Vorrichtung 10" dargestellt. Die elektrische Vorrichtung 10' ist analog zu der Vorrichtung 10' aus Fig. 2 aufgebaut und weist ebenfalls eine unimodale Partikelgrößenverteilung auf, allerdings mit kleineren Partikeln 24a. Das Maximum der Partikelgrößenverteilung der Partikel 24a liegt hierbei bei ca. 10 $\mu$m. Die Partikel 24a sind im Wesentlichen homogen verteilt angeordnet und füllen die Lücken zwischen den Fasern 26 auf. Die Anzahl der unterschiedlichen Partikelgrößen kann auch hier verständlicherweise stark variieren, wobei aus darstellerischen Gründen lediglich die Partikel 24a mit der größten Häufigkeit (Maximum) eingezeichnet sind.

Ein weiterer Unterschied zu den beiden vorangehend beschriebenen Ausführungsformen 10 und 10' besteht darin, dass dier Partikel 24a und die Fasern 26 aus einem metallischen Material bestehen und somit elektrisch leitend sind. Da die Partikel 24a und die Fasern 26 aufgrund ihrer elektrischen Leitfähigkeit ungewollte Kurzschlüsse verursachen können, weist die elektrische Vorrichtung 10" ferner eine elektrisch isolierende Schicht 30 auf. Die elektrisch isolierende Schicht 30 ist zwischen der Umhüllmasse 20 und dem elektrischen Bauteil 12 angeordnet. Die elektrisch isolierende Schicht 30 ist als dünne Schicht ausgebildet. Die elektrisch isolierende Schicht 30 erstreckt sich über die gesamte Grenzfläche zwischen der Umhüllmasse 20 dem elektrischen Bauteil 12 bzw. dem Trägersubstrat 14. Die elektrisch isolierende Schicht 30 umhüllt demnach das elektrische Bauteil 12 und bildet damit eine elektrische Isolierung vor den den Partikeln 24a und den Fasern 26 aus.

Bei der Herstellung der elektrischen Vorrichtung 10 aus Fig. 1 wird zunächst die Zementmasse 22, bspw. in Pulverform bereitgestellt. In die Zementmasse 22 werden anschließend die Partikel 24a, 24b und die Fasern 26 eingemischt. Hierbei muss insbesondere auf die Partikelgrößenverteilung geachtet werden, welche der Fuller-Verteilung mit der hohlraumärmste Partikel-/Kornpackung angenähert ist, um später eine maximale Packungsdichte in der Umhüllmasse 20 zu erreichen. Im Anschluss wird eine flüssige Komponente, bspw. Wasser mit ggf. dem Flussmittel Melflux beigemischt. Die feuchte Umhüllmasse 20 aufweisend die Zementmasse 22, die Partikel 24a, 24b, die Fasern 26 und das Wasser wird dann evakuiert, auf das elektrische Bauteil 12 aufgebracht und in Form gebracht, bspw. mittels Spritzgießen oder Vergießen in Formen. Anschließend werden die Fasern 26 ausgerichtet, bspw. durch Rütteln und/oder Verpressen, wodurch eine Art Faser-Netzwerk ausgebildet wird. Darauf folgend wird die Umhüllmasse 20 wärmebehandelt bzw. getempert, bspw. bei 60°C und 90% relativer Luftfeuchtigkeit, wodurch eine Gelbildung, Kristallisation, Vernadelung und Aushärtung der Zementmasse 22 erfolgt. Hierbei beugt die Luftfeuchte einem Wasserverlust (Wasser-Zement-Wert) vor und die Temperatur bewirkt eine Ausbildung der gewünschten Strukturen. Schließlich wird die Umhüllmasse 20 mit den Partikeln 24a, 24b und den Fasern 26 optional behandelt, dann entformt und ausgelagert, bspw. bei 300°C.

## Patentansprüche

1. Elektrische Vorrichtung mit einem elektrischen Bauteil (12), welches von einer eine Zementmasse (22) aufweisenden Umhüllmasse (20) zumindest teilweise umhüllt ist, **wobei** die Umhüllmasse (20) ferner ein erstes Material aufweisende Partikel (24a, 24b) und ein zweites Material aufweisende Fasern (26) aufweist, wobei das erste Material und das zweite Material eine höhere Wärmeleitzahl als der Zement der Zementmasse (22) aufweisen; **dadurch gekennzeichnet, dass**

   die Partikel (24a, 24b) ein Partikelgemenge aufweisend eine Vielzahl von Partikelgrößen ausbilden; und
   wobei die Partikel (24a, 24b) und die Fasern (26) im Wesentlichen homogen in der Zementmasse verteilt sind,
   wobei die Partikelgrößenverteilung der Partikel (24a, 24b) der Fuller-Verteilung mit einem Körnungsexponent von q = 0,4 angenähert ist.

2. Elektrische Vorrichtung (10) nach Anspruch 1, **dadurch gekennzeichnet, dass** die Zementmasse (22) Tonerdezement aufweist oder aus Tonerdezement besteht.

3. Elektrische Vorrichtung (10) nach Anspruch 1 oder 2, **dadurch gekennzeichnet, dass** das erste Material der Partikel (24a, 24b) und/oder das zweite Material der Fasern (26) eine Kristallstruktur aufweist, insbesondere ein keramisches oder ein metallisches Material ist.

4. Elektrische Vorrichtung (10) nach einem der vorhergehenden Ansprüche, **dadurch gekennzeichnet, dass** die Partikel (24a, 24b) und die Fasern (26) aus einem keramischen und/oder aus einem metallischen Material bestehen.

5. Elektrische Vorrichtung (10) nach einem der vorhergehenden Ansprüche, **dadurch gekennzeichnet, dass** der Anteil der Fasern (26) in einem Bereich von größer oder gleich 5 Gew.-% bis kleiner oder gleich 70 Gew.-% bezogen auf das Gesamtgewicht der Umhüllmasse (22) liegt und/oder der Anteil der Partikel (24a, 24b) in einem Bereich von größer oder gleich 25 Gew.-% bis kleiner oder gleich 82 Gew.-% bezogen auf das Gesamtgewicht der Umhüllmasse (22) liegt.

6. Elektrische Vorrichtung (10) nach einem der vorhergehenden Ansprüche, **dadurch gekennzeichnet, dass** die Partikelgrößenverteilung der Partikel (24a, 24b) in der Umhüllmasse (22) unimodal oder bimodal ist.

7. Elektrische Vorrichtung (10) nach Anspruch 6, **dadurch gekennzeichnet, dass** das Maximum der unimodalen Partikelgrößenverteilung bei ungefähr 10 μm oder 100 μm und dass die Maxima der bimodalen Partikelgrößenverteilung bei ungefähr 10 μm und ungefähr 100 μm liegen.

8. Elektrische Vorrichtung (10) nach einem der vorhergehenden Ansprüche, **gekennzeichnet durch** eine elektrisch isolierende Schicht (30), welche zwischen der Umhüllmasse (20) und dem elektrischen Bauteil (12) angeordnet ist.

9. Elektrische Vorrichtung (10) nach einem der vorhergehenden Ansprüche, **dadurch gekennzeichnet, dass** das elektrische Bauteil (12) ein Halbleiterbauelement (12), ein Sensorelement, eine Induktivität, eine Kapazität, eine Batteriezelle, ein Batteriemodul oder eine Schaltungsanordnung ist.

10. Verfahren zur Herstellung einer elektrischen Vorrichtung (10) mit einem elektrischen Bauteil (12), welches von einer eine Zementmasse (22) aufweisenden Umhüllmasse (20) zumindest teilweise umhüllt wird, insbesondere nach einem der vorhergehenden Ansprüche, mit folgenden Schritten:

   - Bereitstellen der Zementmasse (22);
   - Einmischen der das erste Material aufweisenden Partikel (24a, 24b) in die Zementmasse (22), wobei das erste Material eine höhere Wärmeleitzahl aufweist als der Zement der Zementmasse (22);
   - Einmischen der das zweite Material aufweisenden Fasern (26) in die Zementmasse (22), wobei das zweite Material eine höhere Wärmeleitzahl aufweist als der Zement der Zementmasse (22), wobei die Partikel (24a, 24b) ein Partikelgemenge aufweisend eine Vielzahl von Partikelgrößen ausbilden, wobei das Partikelgemenge an die Fuller-Verteilung mit einem Körnungsexponent von q = 0,4 angenähert ist; und wobei die Partikel (24a, 24b) und die Fasern (26) im Wesentlichen homogen in der Zementmasse verteilt werden;
   - Aufbringen der die Zementmasse (22) mit den das erste Material aufweisenden Partikeln (24a, 24b) und den das zweite Material aufweisenden Fasern (26) aufweisenden Umhüllmasse (20) auf das elektrische Bauteil (12); und
   - Wärmebehandeln der Umhüllmasse (20).

11. Verfahren nach Anspruch 10, **gekennzeichnet durch** den zusätzlichen Schritt Ausrichten der Fasern (26) nach dem Schritt des Aufbringens der Umhüllmasse (20) auf das elektrische Bauteil (12).

12. Verwendung einer Masse aufweisend eine Zementmasse (22) als Umhüllmasse (20) für ein elektrisches Bauteil (12) einer elektrischen Vorrichtung (10) nach einem der Ansprüche 1 bis 9, wobei die Umhüllmasse (20) ferner ein erstes Material aufweisende Partikel (24a, 24b) und ein zweites Material aufweisende Fasern (26) aufweist, wobei das erste Material und das zweite Material eine höhere Wärmeleitzahl als der Zement der Zementmasse (22) aufweisen, wobei die Partikel (24a, 24b) ein Partikelgemenge aufweisend eine Vielzahl von Partikelgrößen ausbilden, die Partikel (24a, 24b) und die Fasern (26) im Wesentlichen homogen in der Zementmasse verteilt sind und wobei die Partikelgrößenverteilung der Partikel (24a, 24b) der Fuller-Verteilung mit einem Körnungsexponent von q = 0,4 angenähert ist.

**Claims**

1. Electrical device having an electrical component (12) at least partly enveloped by an envelope material (20) comprising a cement material (22), **wherein** the envelope material (20) also includes particles (24a, 24b) comprising a first material and fibers (26) comprising a second material, where said first material and said second material have a higher coefficient of thermal conductivity than the cement of the cement material (22); **characterized in that**

   the particles (24a, 24b) form a particle mixture having a multitude of particle sizes; and
   where the particles (24a, 24b) and the fibres (26) are distributed essentially homogeneously in the cement material,
   where the particle size distribution of the particles (24a, 24b) approximates to the Fuller distribution with a grain size exponent of q = 0.4.

2. Electrical device (10) according to Claim 1, **characterized in that** the cement material (22) comprises calcium aluminate cement or consists of calcium aluminate cement.

3. Electrical device (10) according to Claim 1 or 2, **characterized in that** the first material of the particles (24a, 24b) and/or the second material of the fibers (26) has a crystal structure, and is especially a ceramic or metallic material.

4. Electrical device (10) according to any of the preceding claims, **characterized in that** the particles (24a, 24b) and the fibers (26) consist of a ceramic material and/or of a metallic material.

5. Electrical device (10) according to any of the preceding claims, **characterized in that** the proportion of the fibers (26) is within a range from not less than 5% by weight to not more than 70% by weight, based on the total weight of the envelope material (22), and/or the proportion of the particles (24a, 24b) is within a range from not less than 25% by weight to not more than 82% by weight, based on the total weight of the envelope material (22).

6. Electrical device (10) according to any of the preceding claims, **characterized in that** the particle size distribution of the particles (24a, 24b) in the envelope material (22) is unimodal or bimodal.

7. Electrical device (10) according to Claim 6, **characterized in that** the maximum of the unimodal particle size distribution is about 10 $\mu$m or 100 $\mu$m, and **in that** the maxima of the bimodal particle size distribution are about 10 $\mu$m and about 100 $\mu$m.

8. Electrical device (10) according to any of the preceding claims, **characterized by** an electrically insulating layer (30) arranged between the envelope material (20) and the electrical component (12).

9. Electrical device (10) according to any of the preceding claims, **characterized in that** the electrical component (12) is a semiconductor component (12), a sensor element, an inductance, a capacitance, a battery cell, a battery module or a circuit arrangement.

10. Method of producing an electrical device (10) having an electrical component (12) at least partly enveloped by an envelope material (20) comprising a cement material (22), especially according to any of the preceding claims, having the following steps:

    - providing the cement material (22);
    - mixing the particles (24a, 24b) including the first material into the cement material (22), where the first material has a higher coefficient of thermal conductivity than the cement of the cement material (22);
    - mixing the fibers (26) including the second material into the cement material (22), where the second material has a higher coefficient of thermal conductivity than the cement of the cement material (22), where the particles (24a, 24b) form a particle mixture having a multitude of particle sizes, where the particle mixture approximates to the Fuller distribution with a grain size exponent of q = 0.4; and where the particles (24a, 24b) and the fibres (26) are distributed essentially homogeneously in the cement material;
    - applying the envelope material (20) including the cement material (22) comprising the particles (24a, 24b) including the first material and the fibers (26) including the second material to the electrical component (12); and

    - heat-treating the envelope material (20).

11. Method according to Claim 10, **characterized by** the additional step of:

    - aligning the fibers (26) after the step of applying the envelope material (20) to the electrical component (12).

12. Use of a material including a cement material (22) as envelope material (20) for an electrical component (12) of an electrical device (10) according to any of Claims 1 to 9,

    wherein the envelope material (20) further includes particles (24a, 24b) including a first material and fibers (26) including a second material, wherein the first material and second material have a higher coefficient of thermal conductivity than the cement of the cement material (22), where the particles (24a, 24b) form a particle mixture having a multitude of particle sizes, the particles (24a, 24b) and the fibres (26) are distributed essentially homogeneously in the cement material, and where the particle size distribution of the particles (24a, 24b) approximates to the Fuller distribution with a grain size exponent of q = 0.4.

## Revendications

1. Dispositif électrique comprenant un composant électrique (12), lequel est enrobé au moins partiellement par une masse d'enrobage (20) présentant une masse de ciment (22), la masse d'enrobage (20) présentant en outre des particules (24a, 24b) qui présentent un premier matériau et des fibres (26) qui présentent un deuxième matériau, le premier matériau et le deuxième matériau présentant une conductivité thermique supérieure à celle du ciment de la masse de ciment (22) ;
   **caractérisé en ce que**

    les particules (24a, 24b) forment un mélange de particules qui présente une pluralité de tailles de particule ; et
    les particules (24a, 24b) et les fibres (26) étant distribuées de manière essentiellement homogène dans la masse de ciment,
    la distribution de taille de particule des particules (24a, 24b) s'approchant de la distribution de Fuller avec un exposant granulométrique q = 0,4.

2. Dispositif électrique (10) selon la revendication 1, **caractérisé en ce que** la masse de ciment (22) présente du ciment alumineux ou est constituée de ciment alumineux.

3. Dispositif électrique (10) selon la revendication 1 ou 2, **caractérisé en ce que** le premier matériau des particules (24a, 24b) et/ou le deuxième matériau des fibres (6) présente une structure cristalline, est notamment un matériau céramique ou un matériau métallique.

4. Dispositif électrique (10) selon l'une des revendications précédentes, **caractérisé en ce que** les particules (24a, 24b) et les fibres (26) sont constituées d'un matériau céramique et/ou d'un matériau métallique.

5. Dispositif électrique (10) selon l'une des revendications précédentes, **caractérisé en ce que** la part des fibres (26) est comprise dans une plage de 5 % en poids ou plus à 70 % en poids ou moins rapportée au poids total de la masse d'enrobage (22) et/ou la part des particules (24a, 24b) est comprise dans une plage de 25 % en poids ou plus à 82 % en poids ou moins rapportée au poids total de la masse d'enrobage (22).

6. Dispositif électrique (10) selon l'une des revendications précédentes, **caractérisé en ce que** la distribution de taille de particule des particules (24a, 24b) dans la masse d'enrobage (22) est unimodale ou bimodale.

7. Dispositif électrique (10) selon la revendication 6, **caractérisé en ce que** le maximum de la distribution de taille de particule unimodale est d'environ 10 $\mu$m ou 100 $\mu$m et **en ce que** le maximum de la distribution de taille de particule bimodale est d'environ 10 $\mu$m ou 100 $\mu$m.

8. Dispositif électrique (10) selon l'une des revendications précédentes, **caractérisé par** une couche (30) électriquement isolante qui est disposée entre la masse d'enrobage (20) et le composant électrique (12).

9. Dispositif électrique (10) selon l'une des revendications précédentes, **caractérisé en ce que** le composant électrique (12) est un composant semiconducteur (12), un élément capteur, une inductance, un condensateur, une cellule de batterie, un module de batterie ou un montage de circuit.

10. Procédé pour la fabrication d'un dispositif électrique (10) comprenant un composant électrique (12), lequel est enrobé au moins partiellement par une masse d'enrobage (20) présentant une masse de ciment (22), notamment selon l'une des revendications précédentes, comprenant les étapes suivantes :

- fourniture de la masse de ciment (22) ;
- incorporation par mélange des particules (24a, 24b) qui présentent le premier matériau dans la masse de ciment (22), le premier matériau présentant une conductivité thermique supérieure à celle du ciment de la masse de ciment (22) ;
- incorporation par mélange des fibres (26) qui présentent le deuxième matériau dans la masse de ciment (22), le deuxième matériau présentant une conductivité thermique supérieure à celle du ciment de la masse de ciment (22), les particules (24a, 24b) formant un mélange de particules qui présente une pluralité de tailles de particule, le mélange de particules s'approchant de la distribution de Fuller avec un exposant granulométrique q = 0,4 ; et les particules (24a, 24b) et les fibres (26) étant distribuées de manière essentiellement homogène dans la masse de ciment ;
- application de la masse d'enrobage (20) qui présente la masse de ciment (22) avec les particules (24a, 24b) qui présentent le premier matériau et les fibres (26) qui présentent le deuxième matériau sur le composant électrique (12) ; et
- traitement thermique de la masse d'enrobage (20) .

11. Procédé selon la revendication 10, **caractérisé par** l'étape supplémentaire d'alignement des fibres (26) après l'étape d'application de la masse d'enrobage (20) sur le composant électrique (12).

12. Utilisation d'une masse présentant une masse de ciment (22) en tant que masse d'enrobage (20) pour un composant électrique (12) d'un dispositif électrique (10) selon l'une des revendications 1 à 9, la masse d'enrobage (20) présentant en outre des particules (24a, 24b) qui présentent un premier matériau et des fibres (26) qui présentent un deuxième matériau, le premier matériau et le deuxième matériau présentant une conductivité thermique supérieure à celle du ciment de la masse de ciment (22), les particules (24a, 24b) formant un mélange de particules qui présente une pluralité de tailles de particule, les particules (24a, 24b) et les fibres (26) étant distribuées de manière essentiellement homogène dans la masse de ciment, et la distribution de taille de particule des particules (24a, 24b) s'approchant de la distribution de Fuller avec un exposant granulométrique q = 0,4.

**Fig. 1**

**Fig. 2**

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013112267 A1
- US 2008299300 A1